# EUROPEAN PATENT APPLICATION

(11) **EP 4 765 080 A1**
(43) Date of publication of application: **24.06.2026**
(21) Application number: 25214624.6
(22) Date of filing: 10.11.2025
(51) Int. Cl.: G09F 9/302, G09F 9/33

(54) **TILED MIRROR DISPLAY DEVICE**

(30) Priority: 09.12.2024 CN 202411799177
(71) Applicant: InnoLux Corporation, Chu-Nan, Miao-Li 350 (TW)
(72) Inventor: LO, WEI-SUNG, Miao-Li County (TW); YAO, I-AN, Miao-Li County (TW)
(74) Representative: dompatent

(57) **Abstract**

An electronic device (10) includes a first mirror display unit (20), a second mirror display unit (30), and a reflective element (40). The first mirror display unit and the second mirror display unit are disposed adjacent to each other. The reflective element is disposed between the first mirror display unit and the second mirror display unit. Each of the first mirror display unit and the second mirror display unit may comprise a first substrate (21, 31), a second substrate (22, 32) disposed opposite to the first substrate, a light-emitting unit (23, 33) disposed on the first substrate; and a reflective layer (24, 34) disposed between the first substrate and the second substrate, wherein the reflective layer comprises an opening (O1, O2) overlapping the light-emitting unit. Each of the first mirror display unit and the second mirror display unit may further include a light absorbing layer (**25)** and an adhesive layer (**26)**.

## Description

### BACKGROUND

### Technology Field

This invention relates to an electronic device and, in particular, to a mirror display device.

### Description of Related Art

With the development of technology, the display devices have been widely used in all aspects of daily life, such as TVs, computers, mobile phones and other modern information products. Moreover, in recent years, display devices with mirror function have been introduced and gradually popularized. However, the edges or tiling seams of the mirror display devices may have visual discontinuities.

### SUMMARY

This invention provides an electronic device that can provide a reflection effect at the edges or tiling seams of the mirror display device, thereby minimizing the visual discontinuity.

An electronic device includes a first mirror display unit, a second mirror display unit, and a reflective element. The second mirror display unit is disposed adjacent to the first mirror display unit. The reflective element is disposed between the first mirror display unit and the second mirror display unit.

An electronic device includes a first substrate, a second substrate, a light-emitting unit, a reflective layer, an adhesive layer, and a reflective element. The second substrate is disposed opposite to the first substrate. The light-emitting unit is disposed on the first substrate. The reflective layer is disposed between the first substrate and the second substrate, and the reflective layer includes an opening overlapping the light-emitting unit. The adhesive layer is disposed between the first substrate and the second substrate. The reflective element is disposed on a side surface of the reflective layer and a side surface of the adhesive layer.

### BRIEF DESCRIPTION OF THE DRAWINGS

The invention will become more fully understood from the detailed description and accompanying drawings, which are given for illustration only, and thus are not limitative of the present invention, and wherein:
FIG. 1 is a schematic diagram showing the manufacturing process of an electronic device according to an embodiment of this invention;
FIG. 2 is a schematic sectional view of an electronic device according to a first embodiment of this invention;
FIG. 3 is a schematic sectional view of an electronic device according to a second embodiment of this invention;
FIG. 4 is a schematic sectional view of an electronic device according to a third embodiment of this invention;
FIG. 5 is a schematic sectional view of an electronic device according to a fourth embodiment of this invention;
FIG. 6 is a schematic sectional view of an electronic device according to a fifth embodiment of this invention;
FIG. 7 is a schematic sectional view of an electronic device according to a sixth embodiment of this invention;
FIGS. 8A to 8C are schematic sectional views of electronic devices according to different aspects of a seventh embodiment of this invention;
FIGS. 9A and 9B are schematic sectional views of electronic devices according to different aspects of an eighth embodiment of this invention;
FIGS. 10A and 10B are schematic sectional views of electronic devices according to different aspects of a ninth embodiment of this invention;
FIGS. 11A and 11B are schematic sectional views of electronic devices according to different aspects of a tenth embodiment of this invention; and
FIGS. 12A and 12B are schematic sectional views of electronic devices according to different aspects of an eleventh embodiment of this invention.

### DETAILED DESCRIPTION OF THE INVENTION

The present invention will be apparent from the following detailed description, which proceeds with reference to the accompanying drawings, wherein the same references relate to the same elements.

To be noted, without departing from the spirit of the present invention, the features in several different embodiments may be replaced, reorganized, or mixed to complete other embodiments.

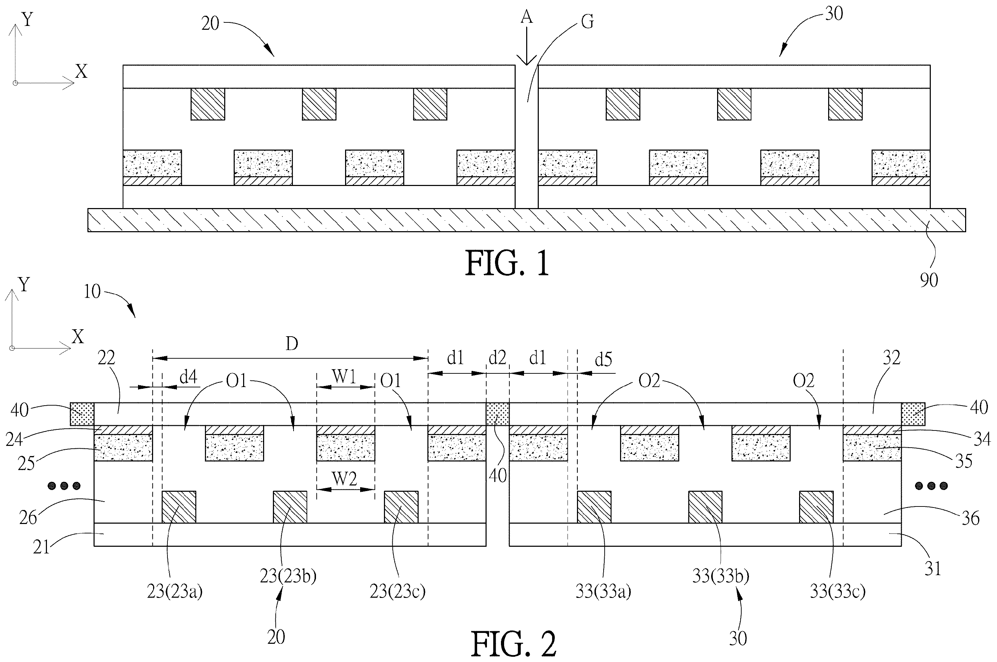

Referring to FIG. 1, the electronic device of this invention includes a first mirror display unit 20, a second mirror display unit 30, and a reflective element. For example, in the manufacturing process of the electronic device, the first mirror display unit 20 and the second mirror display unit 30 can be manufactured separately. Then, the first mirror display unit 20 and the second mirror display unit 30 may be fixedly arranged on a mold 90 (e.g. a carrier plate). In this case, the first mirror display unit 20 and the second mirror display unit 30 can be arranged adjacent to each other along a first direction X, and a gap G may be provided between the first mirror display unit 20 and the second mirror display unit 30. Herein, the first direction X is, for example, parallel to the surface of the mold 90, the first mirror display unit 20, or the second mirror display unit30. Afterwards, the reflective material used to form the reflective element is filled into the gap G along the arrow A (parallel to the second direction Y). According to the different aspects of the reflective material filled into the gap G, the reflective elements of different forms and/or positions can be manufactured between the first mirror display unit 20 and the second mirror display unit 30. Herein, the second direction Y is, for example, perpendicular to the surface of the mold 90, the first mirror display unit 20 or the second mirror display unit 30. The reflective material can be, for example, a polymer adhesive material containing metal powder. The polymer adhesive material can be, for example but not limited to, optical clear adhesive (OCA) or optical clear resin (OCR). The material of the metal powder can be, for example but not limited to, aluminum (Al), molybdenum (Mo), chromium (Cr), silver (Ag), iron (Fe), gold (Au), nickel (Ni), or any combination of the above materials, and this invention is not limited thereto. After the reflective element is formed (or after the polymer adhesive material is cured), the mold 90 can be removed so as to manufacture the electronic devices of different embodiments and different implementations, which will be described in detail below. It should be noted that the electronic device may be, for example but not limited to, a tiled display device, and the gap G may define a tiling seam between any two adjacent mirror display units. In addition, the electronic device may be formed by tiling two or more mirror display units.

FIG. 2 is a schematic sectional view of an electronic device 10 according to a first embodiment of this invention. In this embodiment, the electronic device 10 includes a first mirror display unit 20, a second mirror display unit 30, and a reflective element 40. The first mirror display unit 20 and the second mirror display unit 30 are disposed adjacent to each other, and the reflective element 40 is disposed between the first mirror display unit 20 and the second mirror display unit 30. The first mirror display unit 20 includes a first substrate 21, a second substrate 22, a light-emitting unit 23, and a reflective layer 24. The first substrate 21 and the second substrate 22 are disposed opposite to each other, and the light-emitting unit 23 is disposed on the first substrate 21. The reflective layer 24 is disposed between the first substrate 21 and the second substrate 22, and includes an opening O1 overlapping the light-emitting unit 23. In addition, the first mirror display unit 20 further includes, for example, a light absorbing layer 25 and an adhesive layer 26. The light absorbing layer 25 is disposed at one side of the reflective layer 24 close to the first substrate 21, and the adhesive layer 26 is disposed between the first substrate 21 and the second substrate 22. Similarly, the second mirror display unit 30 includes a first substrate 31, a second substrate 32, a light-emitting unit 33, a reflective layer 34, a light absorbing layer 35, and an adhesive layer 36. The first substrate 31 and the second substrate 32 are arranged opposite to each other, and the light-emitting unit 33 is arranged on the first substrate 31. The reflective layer 34 is arranged between the first substrate 31 and the second substrate 32, and includes an opening O2 overlapping the light-emitting unit 33. The light absorbing layer 35 is arranged at one side of the reflective layer 34 close to the first substrate 31. The adhesive layer 36 is arranged between the first substrate 31 and the second substrate 32.

As mentioned above, each of the first substrates 21 and 31 may include, for example but not limited to, transparent or opaque organic materials and/or inorganic materials, and the material thereof may include rigid materials or flexible materials. The organic materials may include, for example but not limited to, polyimide (PI), polycarbonate (PC), polyethylene terephthalate (PET), other known suitable materials, or any combination of the above materials. Inorganic materials may include, for example but not limited to, glass, quartz, sapphire or ceramics. The materials of the first substrates 21 and 31 of this embodiment include glass as an example, so that the first substrates 21 and 31 are respectively glass substrates.

To be noted, a circuit layer (not shown) may be provided on each of the first substrates 21 and 31. The circuit layer may include, for example, different passive components and/or active components, such as resistors, capacitors, inductors, diodes, MOSFETs, CMOS transistors, BJTs, LDMOS transistors, PMOS transistors, TFTs, or other types of transistors. In addition, the first substrate 21/31 and the corresponding circuit layer can together constitute a driving substrate for driving the light-emitting unit 23/33, which can be, for example but not limited to, a CMOS substrate, a LCOS substrate, a TFT substrate, or other circuit substrates with operating circuits. In this embodiment, the first substrate 21/31 and the circuit layer can together constitute, for example, a TFT substrate.

Each of the second substrates 22 and 32 can be, for example but not limited to, a transparent substrate, such as a glass substrate.

The light-emitting unit 23 can be electrically connected to the circuit layer of the first substrate 21, and the light-emitting unit 33 can be electrically connected to the circuit layer of the first substrate 31. In this case, the pixel definition layers may be formed on the first substrates 21 and 31, respectively. The pixel definition layers may be made of, for example, a negative photoresist and have a plurality of accommodating spaces. Each light-emitting unit 23 may, for example, include three light-emitting elements 23a, 23b and 23c, and each light-emitting unit 33 may, for example, include three light-emitting elements 33a, 33b and 33c. The light-emitting elements 23a, 23b, 23c, 33a, 33b and 33c are respectively arranged in the accommodating spaces of the pixel definition layers. Each light-emitting element 23a, 23b, 23c, 33a, 33b or 33c may include, for example but not limited to, an organic LED (OLED), an inorganic LED (e.g. mini LED or micro LED), a quantum-dot LED (QLED), fluorescence material, phosphor material, or any of other suitable materials, or any combination of the above materials. In this embodiment, three light-emitting elements (e.g. the light-emitting elements 23a, 23b and 23c, or the light-emitting elements 33a, 33b and 33c) in each light-emitting unit may be, for example, a red micro LED, a green micro LED, and a blue micro LED, respectively.

The reflective layer 24 is disposed at one side of the second substrate 22 close to the first substrate 21, and the reflective layer 34 is disposed at one side of the second substrate 32 close to the first substrate 31. In this embodiment, a reflective material layer may be formed on one side of the second substrate 22, and then the portions of the reflective material layer corresponding to the light-emitting elements 23a, 23b and 23c of the light-emitting unit 23 are removed so as to form the reflective layer 24 having a plurality of openings O1. Similarly, a reflective material layer may be formed on one side of the second substrate 32, and then the portions of the reflective material layer corresponding to the light-emitting elements 33a, 33b and 33c of the light-emitting unit 33 are removed so as to form the reflective layer 34 having a plurality of openings O2. To be noted, the width of each opening O1 or O2 (in the first direction X) can be equal to or slightly larger than the width of the corresponding light-emitting element 23a, 23b, 23c, 33a, 33b or 33c. For example, the distance d4 from the inner edge of the opening O1 to the outer edge of the corresponding light-emitting element 23a, 23b or 23c, and the distance d5 from the inner edge of the opening O2 to the outer edge of the corresponding light-emitting element 33a, 33b or 33c can be, for example, less than or equal to 40 µm, or less than or equal to 25 µm, and the present invention is not limited thereto. The material of the reflective layer 24 or 34 can be, for example, a single metal layer, a composite metal layer, a multilayer film material, or a layer of any of other suitable materials. The single metal layer may include, for example, silver, aluminum, or the likes. The composite metal layer may include, for example, a composite structure of metals and metal oxides, such as, for example but not limited to, ITO/Ag/ITO, Ag/ITO, Al/Ag/Al, Ag/Al, or the likes. The multilayer film material may include, for example, a multilayer film with at least three layers of different refractive indices, wherein the high refractive layers and the low refractive layers are interposed with each other. The low refractive material can be, for example but not limited to, SiOx, and the high refractive material can be, for example but not limited to, SiNx, niobium oxide (Nb₂O₅), or the likes.

Each of the light absorbing layer 25 and 35 may be, for example but not limited to, a black photoresist layer, which may be formed on one side of the corresponding reflective layer 24/34 away from the second substrate 22/32 so as to form a black matrix layer (BM). The light absorbing layer 25 can be patterned in accordance with the openings O1 of the reflective layer 24, and the light absorbing layer 35 can be patterned in accordance with the openings O2 of the reflective layer 35. Therefore, the light absorbing layer 25 can be formed with openings corresponding to the openings O1, and the light absorbing layer 35 can be formed with openings corresponding to the openings O2. In this embodiment, as shown in FIG. 2, the reflective layers 24 and 34 are respectively stacked on the light absorbing layers 25 and 35. The width of the light absorbing layer 25 in the first direction X may be, for example, less than or equal to the width of the reflective layer 24, and the width of the light absorbing layer 25 may be, for example, greater than or equal to 50% of the width of the reflective layer 24. The width of the light absorbing layer 35 in the first direction X may be, for example, less than or equal to the width of the reflective layer 34, and the width of the light absorbing layer 35 may be, for example, greater than or equal to 50% of the width of the reflective layer 34. This invention is not limited thereto. Taking the first mirror display unit 20 as an example, between the two adjacent openings O1, the width W2 of the light absorption layer 25 in the first direction X is less than or equal to the width W1 of the reflective layer 24, and the width W2 of the light absorption layer 25 is greater than or equal to 50% of the width W1 of the reflective layer 24. In some embodiments, the distance between one side edge of the light absorption layer 25 and the corresponding side edge of the reflective layer 24 in the first direction X is between 1 µm and 5 µm, and but the distance between one side edge of the light absorption layer 35 and the corresponding side edge of the reflective layer 34 in the first direction X is between 1 µm and 5 µm. This invention is not limited thereto.

Each of the adhesive layers 26 and 36 can be, for example but not limited to, an optical clear adhesive (OCA) or an optical clear resin (OCR). In one embodiment, when manufacturing the first mirror display unit 20, the light-emitting unit 23 can be disposed on the first substrate 21, while the reflective layer 24 and the light absorbing layer 25 can be disposed on the second substrate 22. Then, an adhesive material layer can be provided to bond the structures on the first substrate 21 and the structures on the second substrate 22. In this case, the adhesive material layer can be, for example, an optical clear adhesive or an optical clear resin, which can be cured to form the adhesive layer 26. Similarly, the second mirror display unit 30 can be manufactured in the same way as mentioned above, so the detailed description thereof will be omitted.

In this embodiment, as shown in FIG. 2, the reflective element 40 is disposed between the second substrate 22 of the first mirror display unit 20 and the second substrate 32 of the second mirror display unit 30. It should be noted that the reflective element 40 of this embodiment can be disposed within the tiling seam between the second substrate 22 of the first mirror display unit 20 and the second substrate 32 of the second mirror display unit 30. However, in other embodiments, the reflective element 40 can be arranged slightly larger than the tiling seam between the second substrate 22 of the first mirror display unit 20 and the second substrate 32 of the second mirror display unit 30. In other words, the reflective element 40 can partially overlap the reflective layer 24 of the first mirror display unit 20 and/or the reflective layer 34 of the second mirror display unit 30 in the first direction X, and this invention is not limited thereto. In some embodiments, the reflective element 40 can include, for example but not limited to, a compressible material. In addition, the reflectivity of the reflective element 40 can be, for example, greater than 30%, preferably greater than 60%, and the overall reflectivity of the electronic device 10 can be, for example, greater than 30%.

To be noted, FIG. 2 shows that the first mirror display unit 20 includes three light-emitting elements 23a, 23b and 23c, which construct one light-emitting unit 23 or one pixel. However, in practice, the first mirror display unit 20 can include a plurality of pixels arranged along the first direction X. Similarly, the second mirror display unit 30 also has the same configuration. Herein, FIG. 2 is for an illustration and is not for a limitation. In addition, the electronic device 10 can be formed by tiling two or more mirror display units, and this invention is not limited thereto. In this embodiment, the width (in the first direction X) of one or more pixels (e.g. each pixel includes three light-emitting elements 23a, 23b and 23c) is D. Therefore, the width D can be regarded as the width of the light-emitting area of the first mirror display unit 20 or the second mirror display unit 30. In each mirror display unit (e.g. the first mirror display unit 20 or the second mirror display unit 30), the distance (in the first direction X) between the pixel closest to the reflective element 40 (or the tiling seam) and the edge of each mirror display unit (e.g. the first mirror display unit 20 or the second mirror display unit 30) is d1, and the width (in the first direction X) of the reflective element 40 is d2. Therefore, the distance between the pixel of the first mirror display unit 20 closest to the reflective element 40 (or the tiling seam) and the pixel of the second mirror display unit 30 closest to the reflective element 40 (or the tiling seam) can be defined as (2d1+d2). In order to avoid or reduce the influence of the tiling seam between the first mirror display unit 20 and the second mirror display unit 30 on the displayed images, the above distance (2d1+d2) can be designed to be substantially equal to the distance between any two adjacent pixels in the first mirror display unit 20 or the second mirror display unit 30. For example, the distance (2d1+d2) can be equal to the distance between any two adjacent pixels in the first mirror display unit 20 or the second mirror display unit 30, or the difference therebetween can be within +10%. This invention is not limited thereto.

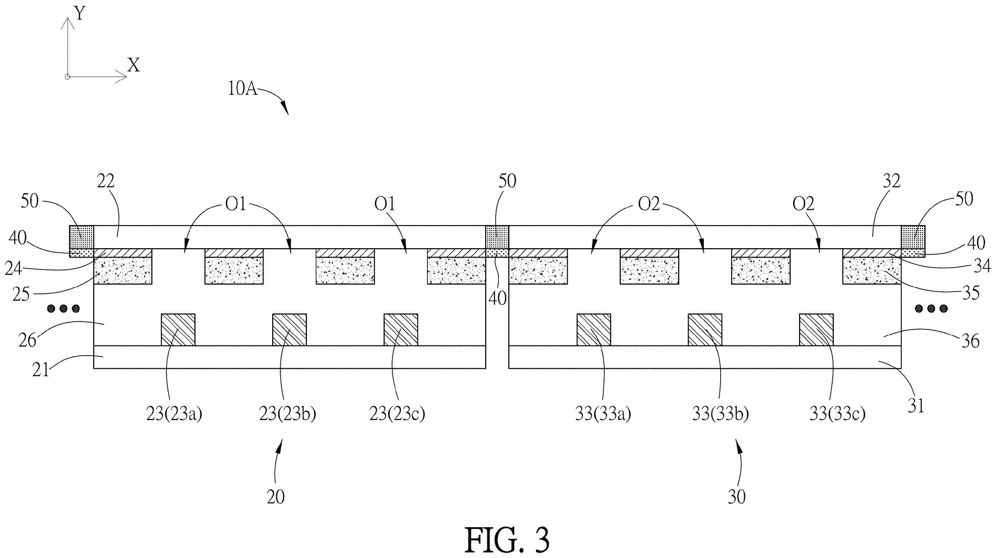

As shown in FIG. 3, compared with the previous embodiment of FIG. 2, the electronic device 10A further includes a refractivity matching layer 50 disposed between the second substrate 22 of the first mirror display unit 20 and the second substrate 32 of the second mirror display unit 30, and the reflective element 40 is disposed between the reflective layer 24 of the first mirror display unit 20 and the reflective layer 34 of the second mirror display unit 30. In this embodiment, the refractive index of the refractivity matching layer 50 is mainly matched to the refractivity of the second substrates 22 and 32 to prevent the external light from generating large-angle refracted light at the interface between the second substrates 22 and 32 and the tiling seam (i.e., the refractivity matching layer 50). For example, with respect to visible light, the difference between the refractive index of the refractivity matching layer 50 and the refractive index of the second substrates 22 and 32 can be less than or equal to 0.2.

The detailed description of the other features of the electronic device 10A can refer to the previous embodiment, and will be omitted here.

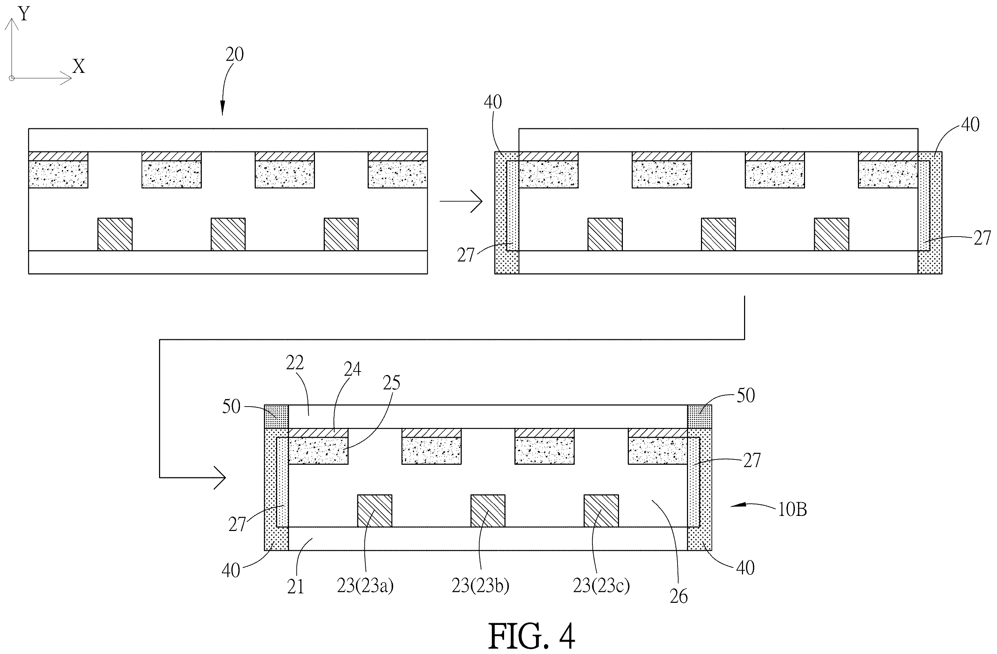

As shown in FIG. 4, compared with the previous embodiment of FIG. 3, the electronic device 10B can be, for example, mainly formed by one mirror display unit (e.g. the first mirror display unit 20), and the reflective element 40 extends downward (in the second direction Y) from the lower surface of the second substrate 22 to the lower surface of the first substrate 21. Therefore, the reflective element 40 is disposed on the side surface of the reflective layer 24, the side surface of the light absorbing layer 25, the side surface of the adhesive layer 26, and the side surface of the first substrate 21. In addition, the first mirror display unit 20 may further include a compressible layer 27 disposed between the adhesive layer 26 and the reflective element 40. In this case, the compressible layer 27 includes, for example, a compressible material. In another case, the reflective element 40 may also include a compressible material, and this invention is not limited thereto. In this embodiment, a first mirror display unit 20 can be obtained first, and then a compressible layer 27 can be formed on the side surface of the first mirror display unit 20, so that the compressible layer 27 is disposed on the side surfaces of the light absorbing layer 25 and the adhesive layer 26. Afterwards, a reflective element 40 can be formed on the side surface of the first mirror display unit 20, so that the reflective element 40 is disposed on the side surfaces of the reflective layer 24, the compressible layer 27 and the first substrate 21. Finally, a refractivity matching layer 50 can be formed on the upper side of the reflective element 40, so that the refractivity matching layer 50 is disposed on the side surface of the second substrate 22. The other features of the electronic device 10B can refer to the description of the aforementioned embodiments, and will be omitted here.

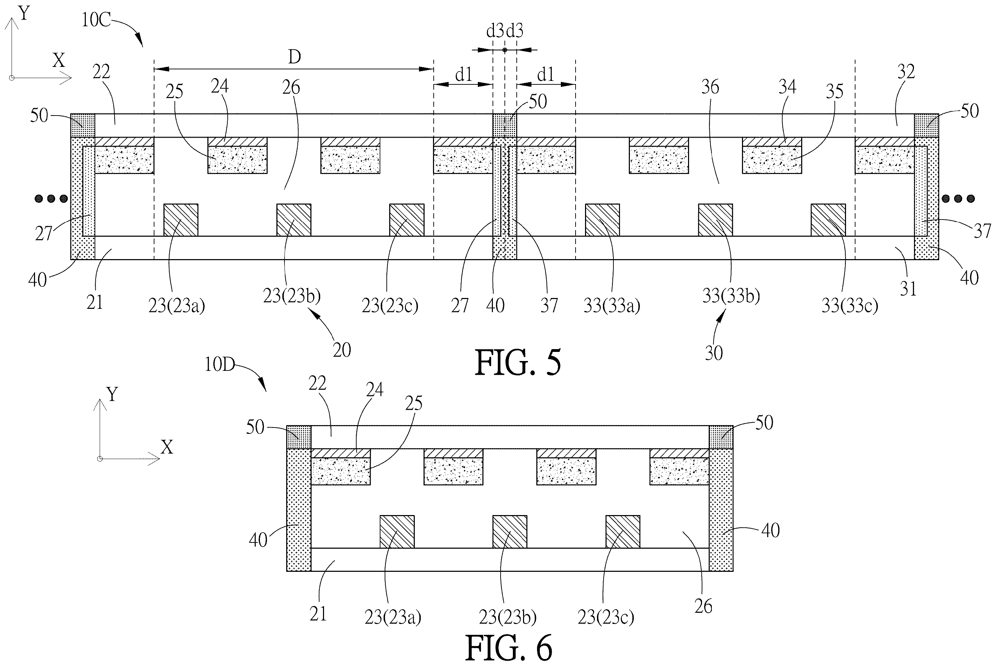

As shown in FIG. 5, compared with the previous embodiment of FIG. 3, the reflective element 40 of the electronic device 10C extends downward (in the second direction Y) from the lower surfaces of the second substrates 22 and 32 to the lower surfaces of the first substrates 21 and 31. Therefore, the reflective element 40 is disposed between the reflective layer 24 and the reflective layer 34, between the light absorbing layer 25 and the light absorbing layer 35, between the adhesive layer 26 and the adhesive layer 36, and between the first substrate 21 and the first substrate 31. In addition, the first mirror display unit 20 further includes a compressible layer 27, which is disposed between the adhesive layer 26 and the reflective element 40, and the second mirror display unit 30 further includes a compressible layer 37, which is disposed between the adhesive layer 36 and the reflective element 40. Each of the compressible layers 27 and 37 includes, for example, a compressible material. In another case, the reflective element 40 may include, for example, a compressible material, and this invention is not limited thereto. In other words, the electronic device 10C of this embodiment may be formed by tiling a plurality of the above-mentioned electronic devices 10B. In this embodiment, the compressible layers 27 and 37 disposed at the tiling seam may be subjected to force during the tiling process, so that the widths thereof can be changed. Therefore, the widths of the compressible layers 27 and 37 located at the tiling seam may be, for example, smaller than the widths of the compressible layers 27 and 37 located at the outermost portions of the electronic device 10C. In detail, in each mirror display unit (e.g., the first mirror display unit 20 or the second mirror display unit 30), the distance (in the first direction X) between the pixel closest to the reflective element 40 (or the tiling seam) and the edge of each mirror display unit (e.g., the first mirror display unit 20 or the second mirror display unit 30) is d1, and the width (in the first direction X) of the reflective element 40 disposed on the side surface of the first mirror display unit 20 and the width of the reflective element 40 disposed on the side surface of the second mirror display unit 30 are d3, respectively. After the first mirror display unit 20 and the second mirror display unit 30 are tiled and connected, the distance between the pixel of the first mirror display unit 20 closest to the reflective element 40 (or the tiling seam) and the pixel of the second mirror display unit 30 closest to the reflective element 40 (or the tiling seam) can be defined as (2d1+2d3). In order to avoid or reduce the influence of the tiling seam between the first mirror display unit 20 and the second mirror display unit 30 on the displayed images, the above distance (2d1+2d3) can be designed to be substantially equal to the distance between any two adjacent pixels in the first mirror display unit 20 or the second mirror display unit 30. For example, the distance (2d1+2d3) can be equal to the distance between any two adjacent pixels in the first mirror display unit 20 or the second mirror display unit 30, or the difference therebetween can be within +10%. This invention is not limited thereto. The other features of the electronic device 10C can refer to the description of the aforementioned embodiments, and will be omitted here.

As shown in FIG. 6, compared with the previous embodiment of FIG. 4, the electronic device 10D is not configured with the compressible layer 27. It should be noted that the reflective element 40 of this embodiment may include, for example, a compressible material. The other features of the electronic device 10D can refer to the description of the aforementioned embodiments, and will be omitted here.

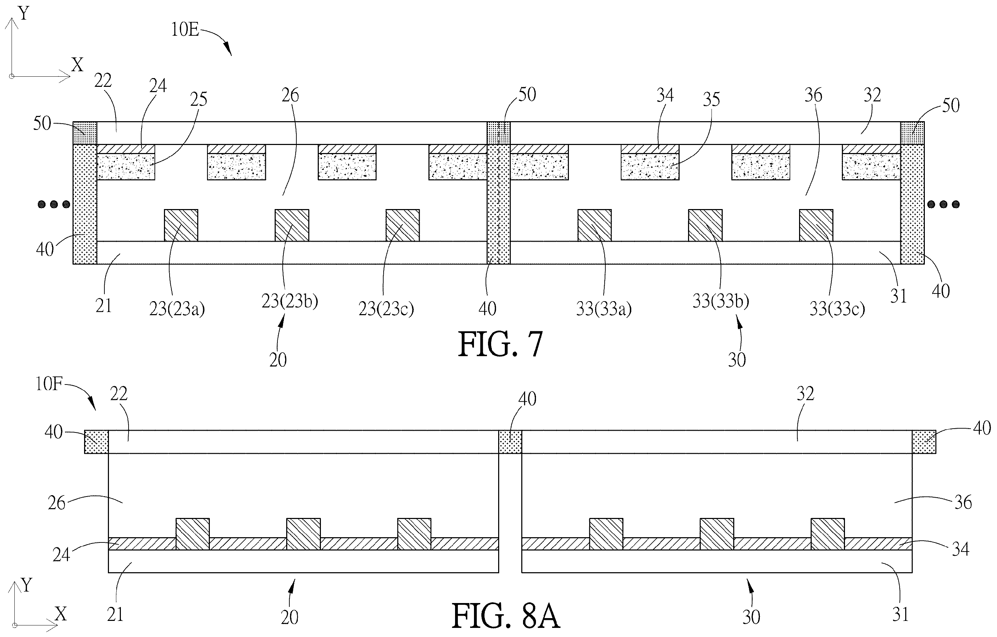

As shown in FIG. 7, compared with the previous embodiment of FIG. 5, the electronic device 10E is not configured with the compressible layers 27 and 37. In other words, the electronic device 10E of this embodiment may be formed by tiling a plurality of the above-mentioned electronic devices 10D. To be noted, the reflective element 40 of this embodiment may include, for example, a compressible material. The other features of the electronic device 10E can refer to the description of the aforementioned embodiments, and will be omitted here.

As shown in FIG. 8A, compared with the previous embodiment of FIG. 2, in the electronic device 10F, the reflective layer 24 of the first mirror display unit 20 is disposed at one side of the first substrate 21 close to the second substrate 22, the reflective layer 34 of the second mirror display unit 30 is disposed at one side of the first substrate 31 close to the second substrate 32, the adhesive layer 26 is disposed between the second substrate 22 and the reflective layer 24, and the adhesive layer 36 is disposed between the second substrate 32 and the reflective layer 34. In this aspect, the reflective element 40 is disposed between the second substrate 22 of the first mirror display unit 20 and the second substrate 32 of the second mirror display unit 30. The other features of the electronic device 10F can refer to the description of the aforementioned embodiments, and will be omitted here.

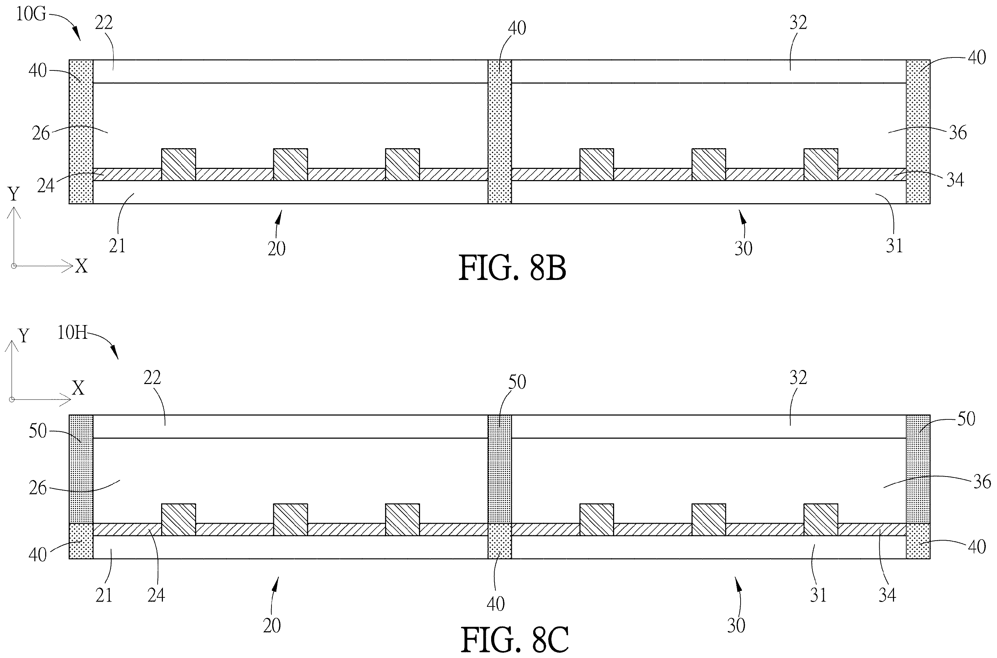

As shown in FIG. 8B, compared with the previous embodiment of FIG. 8A, in the electronic device 10G, the reflective element 40 is disposed between the first substrate 21 and the first substrate 31, between the reflective layer 24 and the reflective layer 34, between the adhesive layer 26 and the adhesive layer 36, and between the second substrate 22 and the second substrate 32. The other features of the electronic device 10G can refer to the description of the aforementioned embodiments, and will be omitted here.

As shown in FIG. 8C, compared with the previous embodiment of FIG. 8A, in the electronic device 10H, the reflective element 40 is disposed between the first substrate 21 and the first substrate 31, and between the reflective layer 24 and the reflective layer 34. In addition, the electronic device 10H further includes a refractivity matching layer 50, which is disposed between the adhesive layer 26 and the adhesive layer 36, and between the second substrate 22 and the second substrate 32. The other features of the electronic device 10H can refer to the description of the aforementioned embodiments, and will be omitted here.

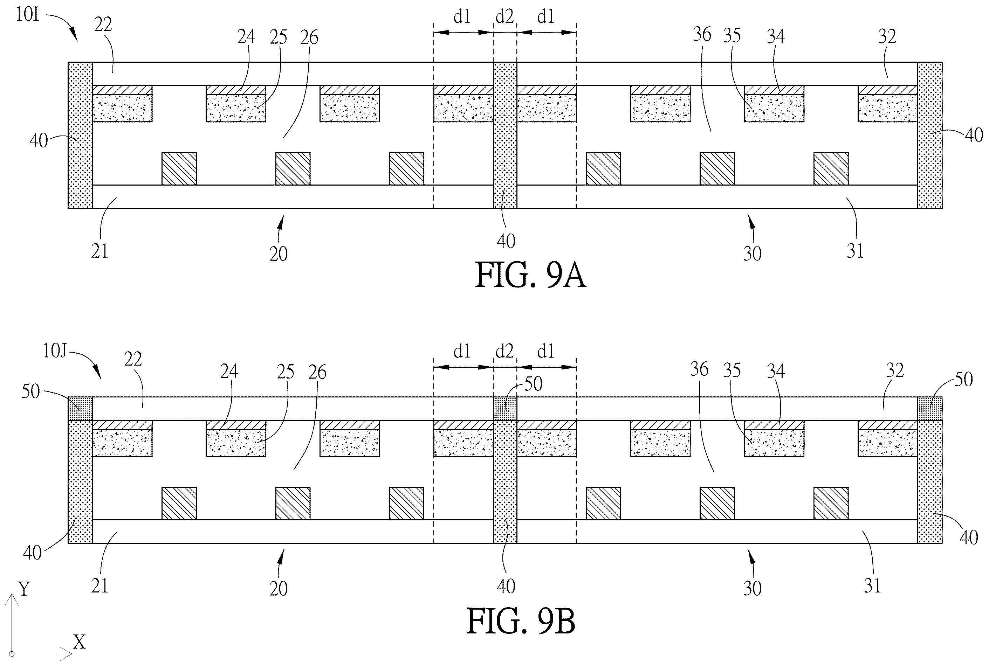

As shown in FIG. 9A, compared with the previous embodiment of FIG. 2, in the electronic device 101, the reflective element 40 extends downward (in the second direction Y) from the upper surfaces of the second substrates 22 and 32 to the lower surfaces of the first substrates 21 and 31. Therefore, the reflective element 40 can be arranged between the second substrate 22 and the second substrate 32, between the reflective layer 24 and the reflective layer 34, between the light absorbing layer 25 and the light absorbing layer 35, between the adhesive layer 26 and the adhesive layer 36, and between the first substrate 21 and the first substrate 31. The other features of the electronic device 10I can refer to the description of the aforementioned embodiments, and will be omitted here.

As shown in FIG. 9B, compared with the previous embodiment of FIG. 9A, in the electronic device 10J, the reflective element 40 is disposed between the reflective layer 24 and the reflective layer 34, between the light absorbing layer 25 and the light absorbing layer 35, between the adhesive layer 26 and the adhesive layer 36, and between the first substrate 21 and the first substrate 31. In addition, the electronic device 10J further includes a refractivity matching layer 50, which is disposed between the second substrate 22 and the second substrate 32. In this case, the distance between the pixel of the first mirror display unit 20 closest to the reflective element 40 (or the tiling seam) and the pixel of the second mirror display unit 30 closest to the reflective element 40 (or the tiling seam) can be defined as (2d1+d2). To be noted, although the structural design of the electronic device 10J as shown in FIG. 9B is substantially the same as the structural design of the electronic device 10E as shown in FIG. 7, they can be manufactured in different ways. For example, the electronic device 10J as shown in FIG. 9B can be manufactured using the manufacturing method described in the embodiment as shown in FIG. 1. Specifically, the first mirror display unit 20 and the second mirror display unit 30 are respectively disposed on a mold 90, and then the reflective element 40 and the refractivity matching layer 50 are filled into the gap G between the first mirror display unit 20 and the second mirror display unit 30. The electronic device 10E as shown in FIG. 7 is manufactured by forming the reflective element 40 and the refractivity matching layer 50 on both sides of the first mirror display unit 20 and the second mirror display unit 30 (as shown in FIG. 6), and then tiling the first mirror display unit 20 and the second mirror display unit 30. The other features of the electronic device 10J can refer to the description of the aforementioned embodiments, and will be omitted here.

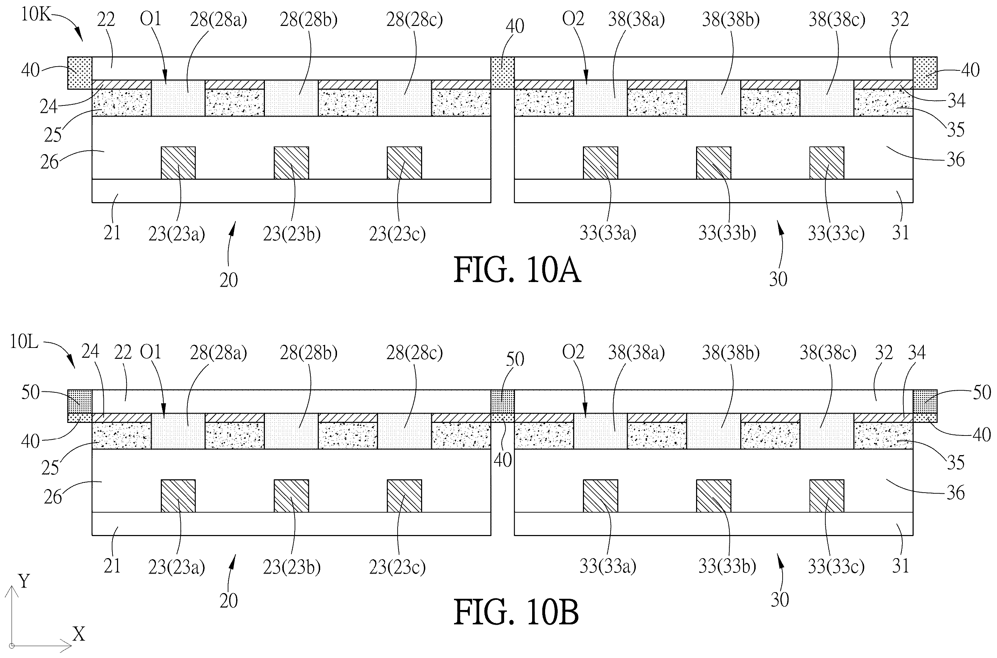

As shown in FIG. 10A, compared with the previous embodiment of FIG. 9A, in the electronic device 10K, the reflective element 40 extends downward (in the second direction Y) from the upper surfaces of the second substrates 22 and 32 to the lower surfaces of the reflective layers 24 and 34. Therefore, the reflective element 40 is disposed between the second substrate 22 and the second substrate 32, and between the reflective layer 24 and the reflective layer 34. To be noted, in other embodiments, the reflective element 40 may be disposed between the second substrate 22 and the second substrate 32, and not between the reflective layer 24 and the reflective layer 34. In addition, the first mirror display unit 20 further includes a color filter unit 28, which is disposed in the openings O1 of the reflective layer 24 and the light absorbing layer 25 and corresponding to the light-emitting unit 23. For example, in one pixel, the color filter unit 28 may include three color filter elements 28a, 28b and 28c, such as a red filter element, a green filter element, and a blue filter element, which are correspondingly disposed below the three light-emitting elements 23a, 23b and 23c, respectively. Similarly, the second mirror display unit 30 further includes a color filter unit 38, which is disposed in the openings O2 of the reflective layer 34 and the light absorbing layer 35 and corresponding to the light-emitting unit 33. For example, in one pixel, the color filter unit 38 may include three color filter elements 38a, 38b and 38c, such as a red filter element, a green filter element, and a blue filter element, which are correspondingly disposed below the three light-emitting elements 33a, 33b and 33c, respectively. The other features of the electronic device 10K can refer to the description of the aforementioned embodiments, and will be omitted here.

As shown in FIG. 10B, compared with the previous embodiment of FIG. 10A, in the electronic device 10L, the reflective element 40 is disposed between the reflective layer 24 and the reflective layer 34. In addition, the electronic device 10L further includes a refractivity matching layer 50, which is disposed between the second substrate 22 and the second substrate 32. The other features of the electronic device 10L can refer to the description of the aforementioned embodiments, and will be omitted here.

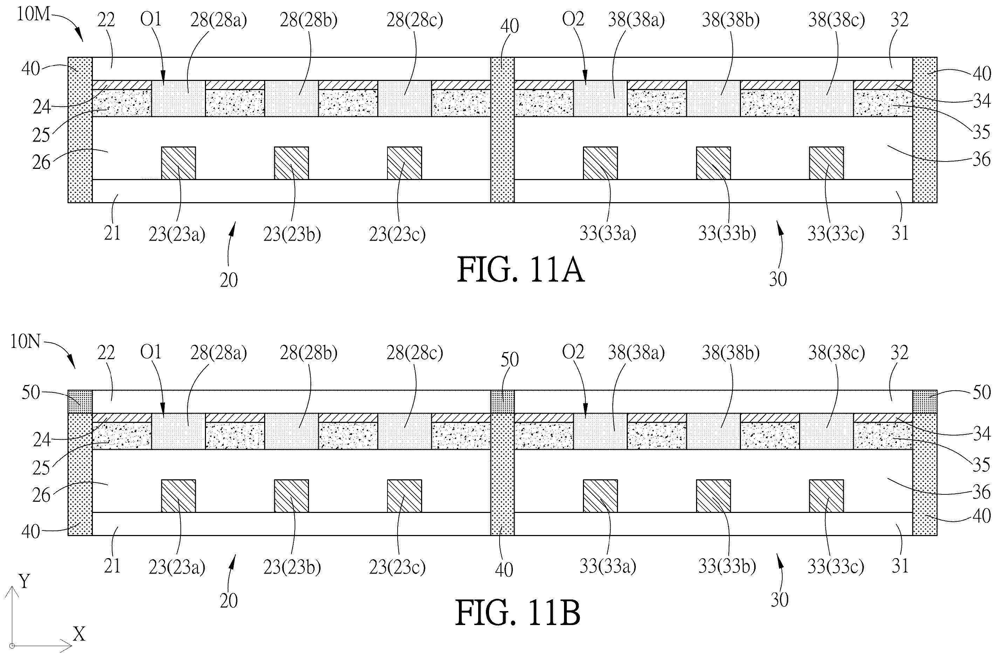

As shown in FIG. 11A, compared with the previous embodiment of FIG. 10A, in the electronic device 10M, the reflective element 40 extends downward (in the second direction Y) from the upper surfaces of the second substrates 22 and 32 to the lower surfaces of the first substrates 21 and 31. Therefore, the reflective element 40 is disposed between the second substrate 22 and the second substrate 32, between the reflective layer 24 and the reflective layer 34, between the light absorbing layer 25 and the light absorbing layer 35, between the adhesive layer 26 and the adhesive layer 36, and between the first substrate 21 and the first substrate 31. The other features of the electronic device 10M can refer to the description of the aforementioned embodiments, and will be omitted here.

As shown in FIG. 11B, compared with the previous embodiment of FIG. 11A, in the electronic device 10N, the reflective element 40 is disposed between the reflective layer 24 and the reflective layer 34, between the light absorbing layer 25 and the light absorbing layer 35, between the adhesive layer 26 and the adhesive layer 36, and between the first substrate 21 and the first substrate 31. In addition, the electronic device 10N further includes a refractivity matching layer 50, which is disposed between the second substrate 22 and the second substrate 32. The other features of the electronic device 10N can refer to the description of the aforementioned embodiments, and will be omitted here.

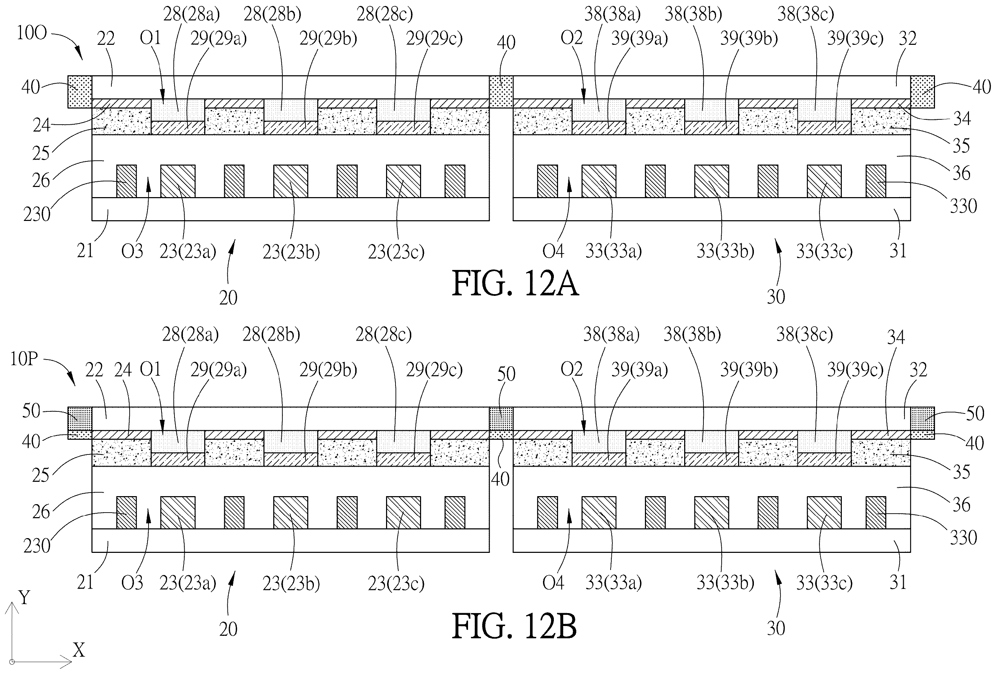

As shown in FIG. 12A, compared with the previous embodiment of FIG. 10A, in the electronic device 10O, the first mirror display unit 20 further includes a light conversion unit 29, which is disposed at one side of the color filter unit 28 close to the first substrate 21 and corresponding to the light-emitting unit 23. For example, in one pixel, the light conversion unit 29 may include three light conversion elements 29a, 29b and 29c, and the corresponding three light-emitting elements 23a, 23b and 23c are, for example, all blue micro LEDs. In this case, the three light conversion elements 29a, 29b and 29c may be, for example, a red-light conversion element, a green-light conversion element, and a light diffusion element, respectively. Similarly, the second mirror display unit 30 further includes a light conversion unit 39, which is disposed at one side of the color filter unit 38 close to the first substrate 31 and corresponding to the light-emitting unit 33. For example, in one pixel, the light conversion unit 39 may include three light conversion elements 39a, 39b and 39c, and the corresponding three light-emitting elements 33a, 33b and 33c are, for example, all blue micro LEDs. In this case, the three light conversion elements 39a, 39b and 39c may be, for example, a red-light conversion element, a green-light conversion element, and a light diffusion element, respectively. For example, the light conversion elements 29a, 29b, 29c, 39a, 39b and 39c of this embodiment may include a phosphor for converting the light emitted from the light-emitting elements 23a, 23b, 23c, 33a, 33b and 33c into suitable color lights, such as red light, green light and blue light. In other embodiments, the light conversion elements 29a, 29b, 29c, 39a, 39b and 39c may, for example, include a quantum dot material. The quantum dot material may have, for example, a core-shell structure, and the core thereof may include, for example but not limited to, CdSe, CdTe, CdS, ZnS, ZnSe, ZnO, ZnTe, InAs, InP, GaP, any of other suitable materials, or any combination of the above materials. Moreover, in this embodiment, the distance from the inner edge of the opening O1 to the outer edge of the corresponding light-emitting element 23a, 23b or 23c and the distance from the inner edge of the opening O2 to the outer edge of the corresponding light-emitting element 33a, 33b or 33c may be, for example but not limited to, less than or equal to 40 µm, or less than or equal to 25 µm. The other features of the electronic device 10O can refer to the description of the aforementioned embodiments, and will be omitted here.

Furthermore, in the electronic device 10O, the first mirror display unit 20 can further include a pixel definition layer (PDL) 230 formed on the first substrate 21. The pixel definition layer 230 is formed with a plurality of openings O3, and the light-emitting elements 23a, 23b and 23c are respectively disposed in the openings O3. Similarly, the second mirror display unit 30 can further include a pixel definition layer 330 formed on the first substrate 31. The pixel definition layer 330 is formed with a plurality of openings O4, and the light-emitting elements 33a, 33b and 33c are respectively disposed in the openings O4. In some embodiments, a material layer of the pixel definition layer 230 (330), such as an organic photoresist material layer, can be formed on the first substrate 21 (31) by a coating process, and then the material layer can be patterned by, for example, a photolithography process to form a structure including a plurality of openings O3 (O4) as shown in FIG. 12A. In the electronic device 10O, the reflective element 40 is disposed between the second substrate 22 and the second substrate 32, and between the reflective layer 24 and the reflective layer 34. However, in other embodiments, the reflective element 40 may be disposed between the second substrate 22 and the second substrate 32, but not between the reflective layer 24 and the reflective layer 34.

As shown in FIG. 12B, compared with the previous embodiment of FIG. 12A, in the electronic device 10P, the reflective element 40 is disposed between the reflective layer 24 and the reflective layer 34, and the electronic device 10P further includes a refractivity matching layer 50 disposed between the second substrate 22 and the second substrate 32. The other features of the electronic device 10P can refer to the description of the aforementioned embodiments, and will be omitted here.

As mentioned above, the electronic device of this invention includes a first mirror display unit, a second mirror display unit, and a reflective element. The second mirror display unit is disposed adjacent to the first mirror display unit, and the reflective element is disposed between the first mirror display unit and the second mirror display unit. Each mirror display unit includes a first substrate, a second substrate disposed opposite to the first substrate, a light-emitting unit disposed on the first substrate, and a reflective layer disposed between the first substrate and the second substrate. The reflective layer includes an opening overlapping the light-emitting unit, and the reflective element is disposed at the side surfaces of the mirror display units. Since the reflective element is disposed between the first mirror display unit and the second mirror display unit (i.e., at the tiling seam), the reflective effect can be provided in the area without a reflective layer, such as the tiling seam or the edges of the mirror display units, thereby effectively minimizing the phenomenon of visual discontinuity.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic device, comprising:
a first mirror display unit;
a second mirror display unit disposed adjacent to the first mirror display unit; and
a reflective element disposed between the first mirror display unit and the second mirror display unit.

2. The electronic device of claim 1, wherein each of the first mirror display unit and the second mirror display unit comprises:
a first substrate;
a second substrate disposed opposite to the first substrate;
a light-emitting unit disposed on the first substrate; and
a reflective layer disposed between the first substrate and the second substrate, wherein the reflective layer comprises an opening overlapping the light-emitting unit.

3. The electronic device of claim 2, wherein the reflective element is disposed between the second substrate of the first mirror display unit and the second substrate of the second mirror display unit.

4. The electronic device of claim 2, wherein the reflective element is disposed between the reflective layer of the first mirror display unit and the reflective layer of the second mirror display unit.

5. The electronic device of claim 4, further comprising:
a refractivity matching layer disposed between the second substrate of the first mirror display unit and the second substrate of the second mirror display unit.

6. The electronic device of claim 2, wherein in one or both of the first mirror display unit and the second mirror display unit, the reflective layer is disposed at one side of the second substrate close to the first substrate.

7. The electronic device of claim 6, wherein each of the first mirror display unit and the second mirror display unit comprises a light absorbing layer disposed at one side of the reflective layer close to the first substrate.

8. The electronic device of claim 2, wherein each of the first mirror display unit and the second mirror display unit further comprises:
an adhesive layer disposed between the first substrate and the second substrate;
wherein, the reflective element is disposed between the reflective layer of the first mirror display unit and the reflective layer of the second mirror display unit, and between the adhesive layer of the first mirror display unit and the adhesive layer of the second mirror display unit.

9. The electronic device of claim 8, wherein each of the first mirror display unit and the second mirror display unit further comprises a compressible layer disposed between the adhesive layer and the reflective element.

10. The electronic device of claim 8, wherein the reflective element comprises a compressible material.

11. An electronic device, comprising:
a first substrate;
a second substrate disposed opposite to the first substrate;
a light-emitting unit disposed on the first substrate;
a reflective layer disposed between the first substrate and the second substrate, wherein the reflective layer comprises an opening overlapping the light-emitting unit;
an adhesive layer disposed between the first substrate and the second substrate; and
a reflective element disposed on a side surface of the reflective layer and a side surface of the adhesive layer.

12. The electronic device of claim 11, wherein the reflective element comprises a compressible material.

13. The electronic device of claim 11, further comprising:
a compressible layer disposed between the adhesive layer and the reflective element.

14. The electronic device of claim 11, wherein the reflective layer is disposed at one side of the second substrate close to the first substrate.

15. The electronic device of claim 14, further comprising:
a light absorbing layer disposed at one side of the reflective layer close to the first substrate.
